# EUROPEAN PATENT SPECIFICATION

(11) **EP 3 674 441 B1**
(45) Date of publication and mention of the grant of the patent: **25.11.2026**
(21) Application number: 19217825.9
(22) Date of filing: 19.12.2019
(51) Int. Cl.: C23C 28/04, C23C 16/27, C23C 30/00

(54) **DIAMOND FILM FOR CUTTING TOOLS**
DIAMANTFILM FÜR SCHNEIDWERKZEUGE
FILM DE DIAMANT POUR OUTILS DE DÉCOUPAGE

(30) Priority: 25.12.2018 JP 2018241145
(43) Date of publication of application: 01.07.2020
(73) Proprietor: UNION TOOL CO., Tokyo (JP)
(72) Inventor: OHORI, Tetsutaro, Shinagawa, Tokyo (JP); HAYASHI, Shin-Ichiro, Shinagawa, Tokyo (JP)
(74) Representative: Kramer Barske Schmidtchen Patentanwälte PartG mbB

(56) References cited:
- EP-A1- 0 449 571
- EP-A1- 2 230 327
- EP-A1- 3 053 682
- CN-B- 103 436 855
- HAUBNER ROLAND ET AL: "Raman Characterisation of Diamond Coatings Using Different Laser Wavelengths", PHYSICS PROCEDIA, ELSEVIER, AMSTERDAM, NL, vol. 46, 29 July 2013 (2013-07-29), pages 71 - 78, XP028685181, ISSN: 1875-3892, DOI: 10.1016/J.PHPRO.2013.07.047
- KIM YOON-KEE ET AL: "Effects of oxygen on diamond synthesis by hot-filament chemical vapor deposition", JOURNAL OF MATERIALS SCIENCE. MATERIALS IN ELECTRONICS, CHAPMAN AND HALL, LONDON, GB, vol. 6, no. 1, 1 February 1995 (1995-02-01), pages 28 - 33, XP002581487, ISSN: 0957-4522

## Description

### TECHNICAL FIELD

The present invention relates to a diamond film for cutting tools.

### BACKGROUND ART

Conventionally, ultra-hard alloy tools have been widely used as cutting tools. Hard films made of TiN, TiAlN, etc., are typically applied to these ultra-hard alloy tools for the purpose of increasing abrasion resistance.

Also, ultra-hard alloy tools coated with a diamond film using chemical vapor disposition as disclosed in, e.g., Patent Document 1 have recently been used for cutting hard carbon materials, Si-containing aluminum alloys, and other nonferrous high-hardness work materials.

However, there is demand for further improvements to conventional diamond films because when a hard material is machined, there are instances where severe abrasion (early abrasion) occurs and tool service life is shortened, or when a soft material is machined, there are instances where deposition occurs, the machining quality suffers, and the tool is damaged.

For example, as recent printed circuit boards (PCB) are becoming thinner and are being fashioned to dissipate more heat, those made from an aluminum composite material including a high-hardness insulating layer or from a fiber-reinforced plastic (FRP) material including high-strength fiber and a resin are often used. Aluminum composite materials are composites made from insulating layers including hard ceramics, etc., and heat-dissipating layers of soft aluminum, and FRP materials are composites made from hard high-strength fibers and soft resins.

When a conventional diamond film is used to machine such composites, the diamond film suffers severe abrasion when a hard portion (a high-hardness ceramic, a high-strength fiber, or another hard-to-cut material) is machined, and the aluminum, the resin, etc., is deposited on the tool surface when a soft portion (aluminum, resin, or another material susceptible to deposition) is machined.

### [Prior Art Documents]

### [Patent Documents]

[Patent Document 1] Japanese Laid-open Patent Application No. 2003-25117

CN 103 436 855 B relates to a preparation method of a milling cutter diamond composite coating.

HAUBNER ROLAND ET AL: "Raman Characterisation of Diamond Coatings Using Different Laser Wavelengths", PHYSICS PROCEDIA, ELSEVIER, AMSTERDAM, NL, vol. 46, 29 July 2013 (2013-07-29), pages 71-78, XP028685181, relates to Raman characterisation of diamond coatings using different laser wavelengths.

KIM YOON-KEE ET AL: "Effects of oxygen on diamond synthesis by hot-filament chemical vapor deposition", JOURNAL OF MATERIALS SCIENCE. MATERIALS IN ELECTRONICS, CHAPMAN AND HALL, LONDON, GB, vol. 6, no. 1, 1 February 1995 (1995-02-01), pages 28-33, XP002581487, describes the effects of oxygen on diamond synthesis by hot-filament chemical vapor deposition.

EP 3 053 682 A1 discloses a cutting tool and a method for manufacturing a cut product using the same.

EP 0 449 571 A1 discloses a polycrystalline diamond tool and a method for producing the polycrystalline diamond tool.

EP 2 230 327 A1 discloses a diamond coating for a cutting tool.

### SUMMARY OF THE INVENTION

### PROBLEMS THE INVENTION IS INTENDED TO SOLVE

As a result of research on the film composition and film layer configuration of diamond films in view of the current situation described above, the researchers found that the problems described above can be solved by devising the film composition and the film layer configuration, thereby providing a diamond film for cutting tools which has excellent adhesiveness with a base material, which exhibits excellent abrasion resistance and deposition resistance even when used to machine a composite including a material susceptible to deposition and an aluminum composite material, an FRP material, or another hard-to-cut material, and which can exhibit excellent cutting performance over a long period of time.

### MEANS FOR SOLVING THE PROBLEMS

The main points of the present invention will now be described.

The present invention relates to a diamond film for cutting tools formed on a base material in accordance with claim 1.

### EFFECTS OF THE INVENTION

Being constituted as described above, the present invention is a diamond film for cutting tools which has excellent adhesiveness with a base material, which exhibits excellent abrasion resistance and deposition resistance even when used to machine a composite including a hard-to-cut material and a material susceptible to deposition, and which can exhibit excellent cutting performance over a long period of time.

### BRIEF DESCRIPTION OF THE DRAWINGS

FIG. 1 is a schematic illustrative cross-sectional view of a configuration of a present example;
FIG. 2 is a graph showing a Raman spectrum (a) and the results of peak separation (b) at a measurement position A of the present example;
FIG. 3 is a graph showing a Raman spectrum (a) and the results of peak separation (b) at a measurement position B of the present example;
FIG. 4 is a table showing experiment results;
FIG. 5 is a photograph showing a cross-sectional TEM image (bright field image); and
FIG. 6 is a photograph showing a cross-sectional TEM image (dark field image).

### BEST MODE FOR CARRYING OUT THE INVENTION

Preferred embodiments of the present invention will be briefly described by showing the operation of the present invention.

With a diamond film for cutting tools in which the intensity ratio [IN/IJ] of the IJ and IN is 0.01-0.30 (inclusive) at the measurement position A and 1.00-30.25 (inclusive) at the measurement position B, it is possible to minimize early abrasion caused by a hard-to-cut material and deposition of a material susceptible to deposition (refer to the experiments described hereinafter).

Therefore, a cutting tool coated with the diamond film according to the present invention will be able to exhibit excellent abrasion resistance and deposition resistance even when used to machine a composite including an aluminum composite material, an FRP material, or another hard-to-cut material and a material susceptible to deposition, and well as exhibiting excellent cutting performance over a long period of time.

### EXAMPLES

Specific examples of the present invention will now be described on the basis of the drawings.

The present example is a diamond film for cutting tools formed on a base material, and assuming the Raman scattering spectrum measured by spectroscopic analysis of Raman scattering of this diamond film for cutting tools is the sum of the following (1)-(7) Gaussian functions, when the peaks of the Raman scattering spectrum are separated, the peak intensity of J is defined as IJ, the peak intensity of N is defined as IN, and the intensity ratio [IN/IJ] of IJ and IN is 0.01-0.30 (inclusive) at an arbitrary measurement position A in a range of 0.5 µm in a film surface direction from a base material surface, and is 1.0-30.25 (inclusive) at an arbitrary measurement position B in a range of 0.5 µm in a base material direction from a film surface.
(1) J, having a peak at a Raman shift of 1550 ± 40 cm⁻¹
(2) K, having a peak at a Raman shift of 1500 ± 150 cm⁻¹ and a half-value width of 200 cm⁻¹ or more
(3) L, having a peak at a Raman shift of 1470 ± 30 cm⁻¹
(4) M, having a peak at a Raman shift of 1340 ± 40 cm⁻¹
(5) N, having a peak at a Raman shift of 1330 ± 20 cm⁻¹ and a half-value width of 20 cm⁻¹ or less
(6) P, having a peak at a Raman shift of 1200 ± 40 cm⁻¹
(7) Q, having a peak at a Raman shift of 1130 ± 20 cm⁻¹

From the results of spectroscopic analysis of Raman scattering of various diamond films, and the results of research on the abrasion states of diamond films when ceramics and other hard materials are machined, these results having been acquired the inventors et al., the Raman scattering spectra obtained by spectroscopic analysis of Raman scattering of these diamond films were assumed to be the sum of the seven Gaussian functions, the peaks of the Raman scattering spectra were separated using a "spectra Manager ver. 2: curve fitting" made by Jasco Corporation, and conditions under which a film composition having excellent abrasion resistance and deposition resistance was obtained were specified from various experiment results. In the present example, spectroscopic analysis of Raman scattering was performed using laser light having a wavelength of 532 nm.

Specifically, the present example is a diamond film for cutting tools formed on a base material of a cutting tool, and is configured at least from a fine crystalline diamond film portion directly on top of the base material and a diamond film portion having good crystallinity and a large crystal grain diameter in a film surface, the ratio [IN/IJ] being within a predetermined numeral value range.

Each part will now be specifically described.

In the present example, the base material is made of an ultra-hard alloy composed of hard grains having WC as a main component and a bonding material having Co as the main component. The average grain diameter of the WC grains is set at 0.3-3 *µ*m (inclusive), and the Co content is set at 3%-15% (inclusive) by weight.

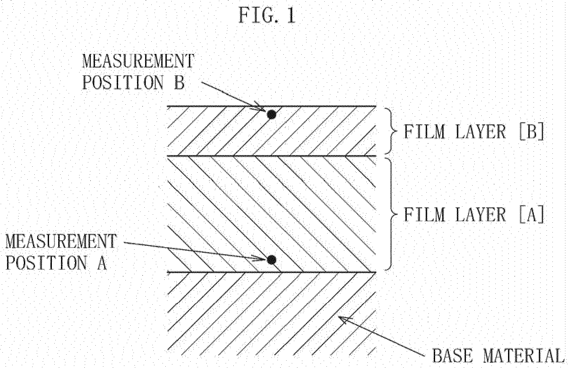

A diamond film is formed on the base material so as to yield a predetermined measurement result when a film cross-section of a tool distal end is subjected to spectroscopic analysis of Raman scattering, whereby measurement position A (a predetermined range in the film surface direction from directly above the base material) in FIG. 1 can be identified as a fine crystalline diamond film, measurement position B (a predetermined range in the base material direction from the film surface) can be identified as a diamond film having good crystallinity, and a diamond film having excellent abrasion resistance and deposition resistance can be obtained.

Specifically, the measurement position A is an arbitrary position in a range of 0.5 *µ*m in the film surface direction from the surface of the base material, and when the Raman scattering spectrum is divided into peaks at this measurement position A, the film has a ratio [IN/IJ] in the range of 0.01-0.30 (inclusive). This is because excellent abrasion resistance is obtained at a ratio [IN/IJ] of 0.01-0.30 (inclusive) at measurement position A. This is believed to be because a non-diamond component is more abundant in a predetermined range in the side adjacent to the base material surface in the diamond film, and this non-diamond component lessens machining shock when the ceramic, etc., is machined, whereby peeling of the film is minimized, dislodging of crystal grains is minimized, and abrasion resistance can be improved.

The measurement position B is an arbitrary position in a range of 0.5 µm in the base material direction from the film surface, and when the Raman scattering spectrum is divided into peaks at this measurement position B, the film has a ratio [IN/IJ] in the range of 1.00-30.25 (inclusive). A ratio [IN/IJ] in the range of 1.00-30.25 (inclusive) at measurement position B is because good deposition resistance is attained. This is presumably because a diamond component is more abundant in a predetermined range in the side adjacent to the film surface, and microscopic surface roughness is smoothed, whereby the deposition resistance of the aluminum, resin, or other soft materials can be improved.

Specifically, good abrasion resistance and deposition resistance can be attained in an aluminum composite material, an FRP material, etc., including a high-hardness insulating layer by using a diamond film in which [IN/IJ] at measurement position A is 0.01-0.30 (inclusive) and [IN/IJ] at measurement position B is in a range of 1.00-30.25 (inclusive).

However, it is known that a peak appears at approximately 1140 cm⁻¹ when film-forming conditions are changed and the crystal grain diameter of the diamond film is reduced. The present invention is characterized in that the crystal grain diameter is small in the range of measurement position A, and can therefore also be characterized using a peak Q that appears at 1130 ± 20 cm⁻¹ when the Raman scattering spectrum is split into peaks as described above.

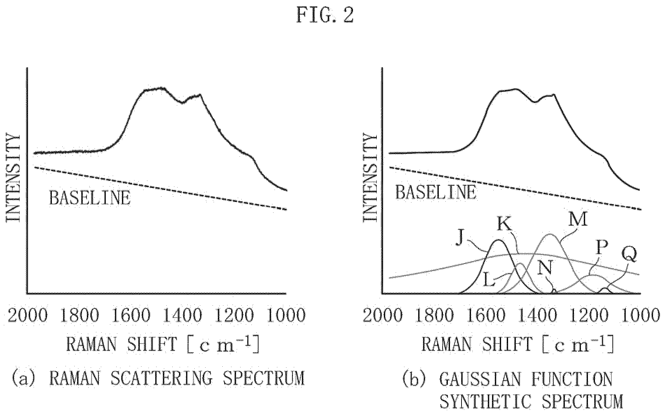

Denoting the peak intensity of Q as IQ, good abrasion resistance is attained when, in addition to the condition described above, an intensity ratio [IN/IQ] between IQ and IN is 0.15-1.30 (inclusive) at the measurement position A. This is presumably because at a ratio [IN/IQ] of 0.15-1.30 (inclusive), the proportion of fine crystalline diamond increases, whereby grain boundaries increases as the crystal grains become finer, and when a hard ceramic or another material is machined, the spread of cracks due to machining shock, etc., is inhibited (fracture toughness improves) and the crystal grains are less likely to become dislodged, leading to an improvement in abrasion resistance. FIG. 2 shows a Raman spectrum and the results of peak separation at measurement position A of the present example.

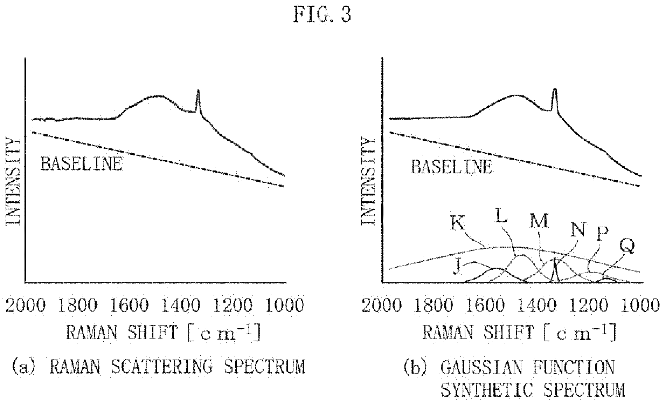

Measurement position B is characterized in that crystal grain diameter is large, and a diamond film having a small proportion of fine crystalline diamond is therefore preferred. Specifically, abrasion resistance is satisfactory when, in addition to the conditions described above, [IN/IQ] is 1.50-45.36 (inclusive) at the measurement position B. This is presumably because when [IN/IQ] is 1.50-45.36 (inclusive), the crystal grain diameter of the diamond increases, whereby microscopic surface roughness of the film surface affecting deposition can be reduced, and deposition resistance therefore improves. FIG. 3 shows a Raman spectrum and the results of peak separation at measurement position B of the present example.

The present invention has a two-layer configuration composed of a base-material-side fine crystalline diamond film layer [A] provided directly on top of the base material and including measurement position A, and a film-surface-side diamond film layer [B] provided on the film layer [A], including measurement position B, and having a large crystal grain diameter and good crystallinity. Specifically, this two-layer configuration includes the film layer [A] having a satisfactory Raman spectrum at measurement position A, and the film layer [B] having a satisfactory Raman spectrum at measurement position B.

A width of the crystal grains in a direction perpendicular to a film growth direction in the film layer [A] is 0.005-0.15 µm (inclusive). The film layer [A] has the characteristic of lessening the shock during machining and improving abrasion resistance due to smaller crystal grains and increased crystal grain boundaries. When the width of the crystal grains in a direction perpendicular to the film growth direction in the film layer [A] is less than 0.005 *µ*m, the hardness of the diamond film cannot be maintained due to there being many crystal grain boundaries, and sufficient machining performance is believed to be unattainable. When the width of the crystal grains in a direction perpendicular to the film growth direction in the film layer [A] exceeds 0.15 *µ*m, it is believed that there is a loss of abrasion resistance due to grain boundary fracturing that occurs with larger crystal grain size. For these reasons, the width of the crystal grains in a direction perpendicular to the film growth direction in the film layer [A] is preferably in a range of 0.005-0.15 *µ*m (inclusive).

The width of the crystal grains in a direction perpendicular to a film growth direction in the film layer [B] is 0.2-30 *µ*m (inclusive). The film layer [B] has the characteristic of improving deposition resistance due to the crystal grains being larger and the microscopic surface roughness thereby being reduced. When the width of the crystal grains in a direction perpendicular to a film growth direction in the film layer [B] is less than 0.2 *µ*m, there is believed to be a loss of deposition resistance because the microscopic surface roughness increases. When the width of the crystal grains in a direction perpendicular to a film growth direction in the film layer [B] is greater than 30 *µ*m, it is believed that the area of the crystal grain boundaries increases and crystal grains become dislodged more readily even with little force. For these reasons, the width of the crystal grains in a direction perpendicular to the film growth direction in the film layer [B] is preferably in a range of 0.2-30 *µ*m (inclusive).

The film thickness (total film thickness) of the present invention is 5-20 *µ*m (inclusive). This is because tool performance is not attained at a thickness less than 5 *µ*m, and when the thickness exceeds 20 *µ*m, the tool edges become too rounded, whereby burrs are formed readily, warping occurs readily, etc., and substrate machining quality suffers.

According to experimental examples described hereinafter, a thickness of the film layer [B] is set to a range of 0.2-10 *µ*m (inclusive). If the thickness of the film layer [B] is 0.2 *µ*m or more, deposition resistance can be ensured. When the thickness of the film layer [B] is less than 0.2 *µ*m, sufficient deposition resistance is not attained, which is believed to be because aluminum, etc., is readily deposited during machining of the base material. Additionally, the thickness of the film layer [B] is 10 *µ*m or less. When the thickness of the film layer [B] exceeds 10 *µ*m, the area of crystal grain boundaries increases and crystal grains become dislodged more readily even with little force. This leads to the film layer [A] being exposed and the effect of deposition resistance being unattainable. Therefore, the thickness of the film layer [B] is preferably in a range of 0.2-10 *µ*m (inclusive).

Furthermore, the percentage of the film layer [B] is preferably a thickness of 1%-50% (inclusive) of the total film thickness (therefore, the percentage of the film layer [A] is preferably 50%-99% (inclusive)).

The present example is configured such that the film layer [A] extends past the range of the measurement position A and the entire film layer satisfies the predetermined ratios [IN/IJ] and [IN/IQ], while the film layer [B] extends past the range of the measurement position B and the entire film layer satisfies the predetermined ratios [IN/IJ] and [IN/IQ], but if these ratios are both satisfied in at least the ranges of measurement position A and measurement position B, it is confirmed that sufficient abrasion resistance and deposition resistance are attained.

As long as the film satisfies the Raman scattering spectrum at the above-described measurement positions A and B, the film is not limited to the configuration of the present example. In an embodiment outside the scope of the present invention, the film may have a single-layer configuration or a multi-layer configuration of three or more layers, the film may be configured having a gradient structure in which the film structure is not uniform along the film growth direction, or the film may have a combination of these configurations. For the film to exhibit sufficient performance, a layer having high abrasion resistance, in which [IN/IJ] is in a range of 0.01-0.30 (inclusive), must have a certain thickness relative to the thickness of the entire film; preferably 50%-99% (inclusive) relative to the thickness of the entire film.

In the present example, the diamond film can be formed on the base material by a hot filament method or another vapor-phase diamond synthesis method. In this case, the diamond film formed on directly on the base material can be formed with good adhesiveness by being formed after the base material surface has been subjected to a roughening treatment by shot blasting, chemical agents, electrolytic treatment, etc.

In the present example, due to the crystal grains of diamond directly on the base material being fine crystals as described above, abrasion resistance with ceramics, glass, carbon fibers, etc., is improved, and the crystal grains of diamond near the film surface are increased in size, whereby deposition resistance with respect to aluminum and resins can be improved.

Therefore, the diamond film of the present example has good adhesiveness and therefore does not peel readily during cutting, the diamond film has good abrasion resistance and deposition resistance with composites of soft materials and hard materials such as aluminum composite materials and FRP materials, and the tool service life of the cutting tool can be greatly extended.

Experimental examples that support the results of the present example will now be described.

A hot-filament chemical vapor-deposition device was used in an ultra-hard alloy router bit (shank diameter ø3.175, diameter ø2) for machining PCBs, of which the parent material was an ultra-hard alloy composed of hard grains having WC as a main component and a bonding material having Co as the main component, and diamond films were formed while introducing H₂ gas, CH₄ gas, and O₂ gas so that the router bit temperature reached 650°C to 800°C and the gas pressure was controlled to be constant, for example, 500 Pa to 1500 Pa. The gas flow rate ratio H₂:CH₄:O₂ was 100:1-10:0-5. The layer configuration of the films had a single-layer or two-layer configuration for the sake of simpler comparisons. Specifically, in Experimental Example 1, when the diamond film was formed on the film layer A, the pressure reached 500 Pa and the gas flow rate ratio H₂:CH₄:O₂ was 100:3:1, and when the diamond film was formed on the film layer B, the pressure reached 500 Pa and the gas flow rate ratio H₂:CH₄:O₂ was 100:1:1.

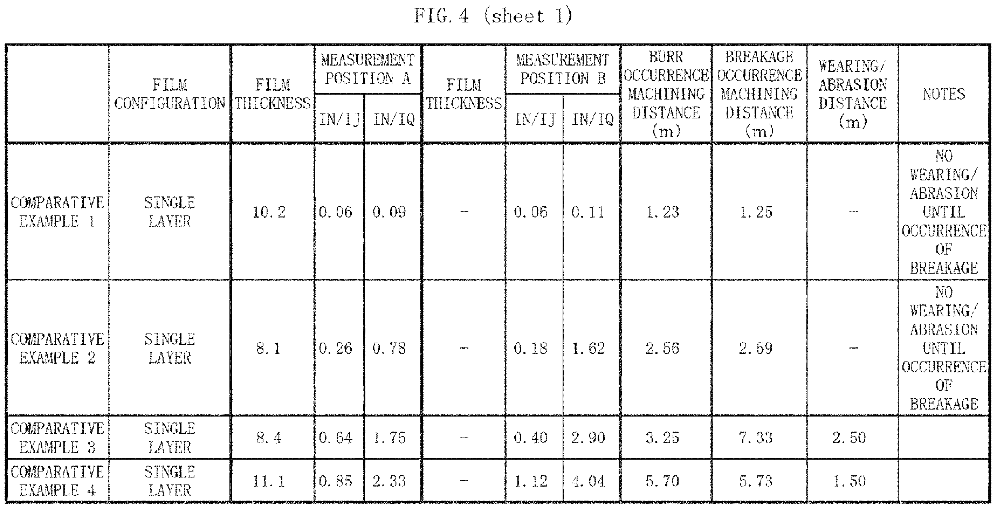

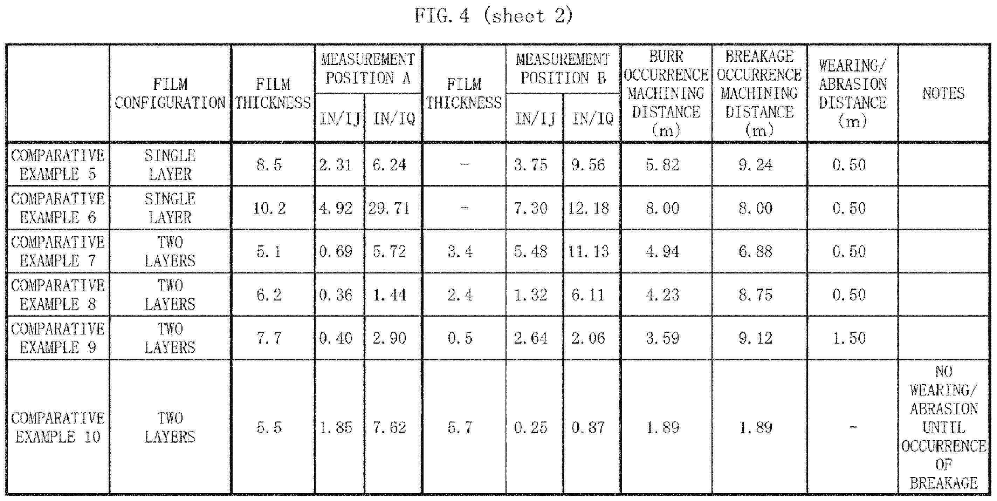

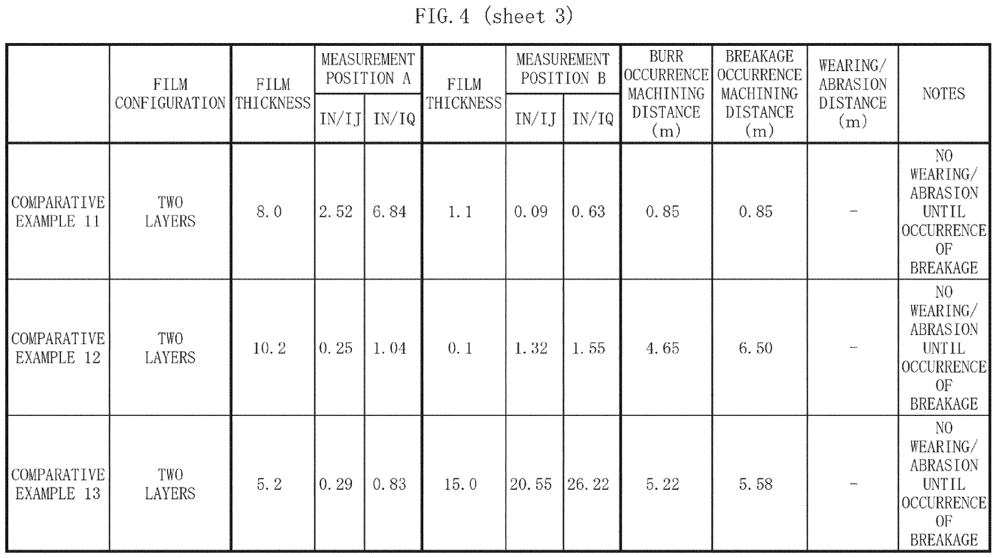

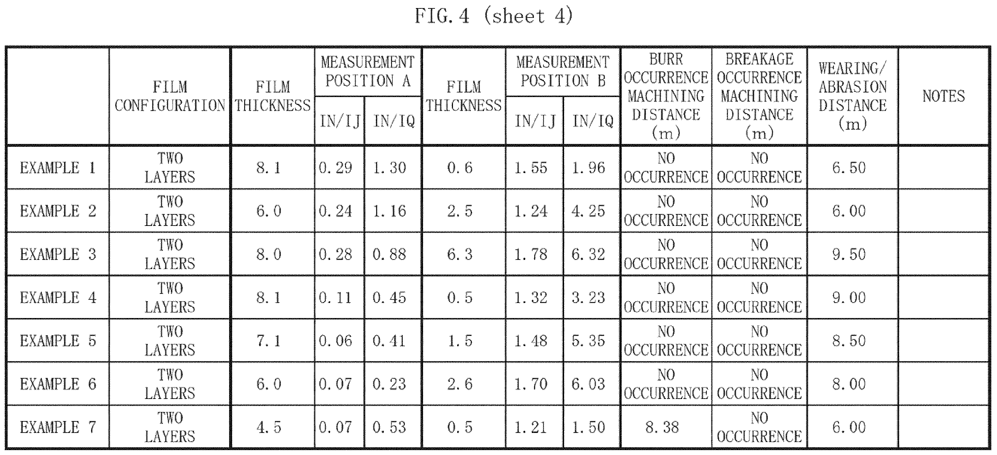

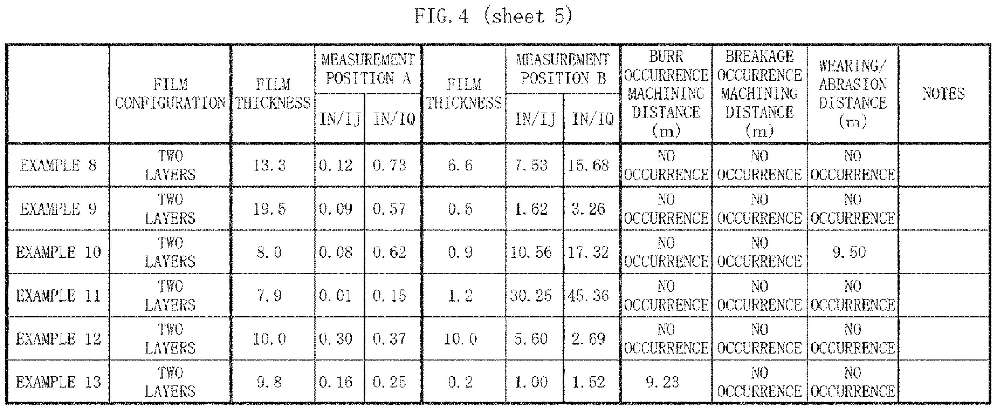

A cutting test was performed in which a router bit coated with the diamond films shown in FIG. 4 was used as a cutting tool, and the material being cut was an aluminum composite substrate (substrate thickness: 1.0 mm, insulating layer: 0.12 mm) including a high-hardness insulating layer. Grooves were machined at a rotational speed of 30000 min⁻¹, a feed rate in X and Y directions of 600 mm/min, a feed rate in a Z direction of 100 mm/min, and an axial-direction incision depth of 1 mm, the substrate and the tool were checked at machining intervals of 500 mm (0.5 m), and the substrate was machined and evaluated at a maximum of 10 m.

Deposition resistance was evaluated using a burr formation machining distance, which is a machining distance reached before a burr is formed during substrate machining, and a breakage occurrence machining distance, which is a machining distance reached before the tool breaks.

Abrasion resistance was evaluated using a wearing/abrasion distance, which is a distance reached before the film becomes worn during substrate machining and the ultra-hard alloy parent material, which is the base material, becomes exposed.

The results of the machining evaluations are shown in FIG. 4. From the results in FIG. 4, it is clear that in comparison with router bits coated with diamond films of the comparative examples, router bits coated with diamond films of the experimental examples have excellent tool service life with respect to cutting an aluminum composite material including a high-hardness insulating layer.

From the above, it was successfully confirmed that with the diamond film according to the present example, it is possible to minimize early abrasion and deposition during cutting, and it is possible to improve tool service life with respect to an aluminum composite material including a high-hardness insulating layer, an FRP material, or another composite material.

An example shall be described in which the film thickness and crystal grain diameter of the present example are set to the aforementioned ranges.

Upon observation of the film of experimental example 2 of FIG. 4 using XTEM, the following was discovered. The thickness of the film layer [A] was approximately 6.0 *µ*m, and the thickness of the film layer [B] was approximately 2.5 *µ*m.

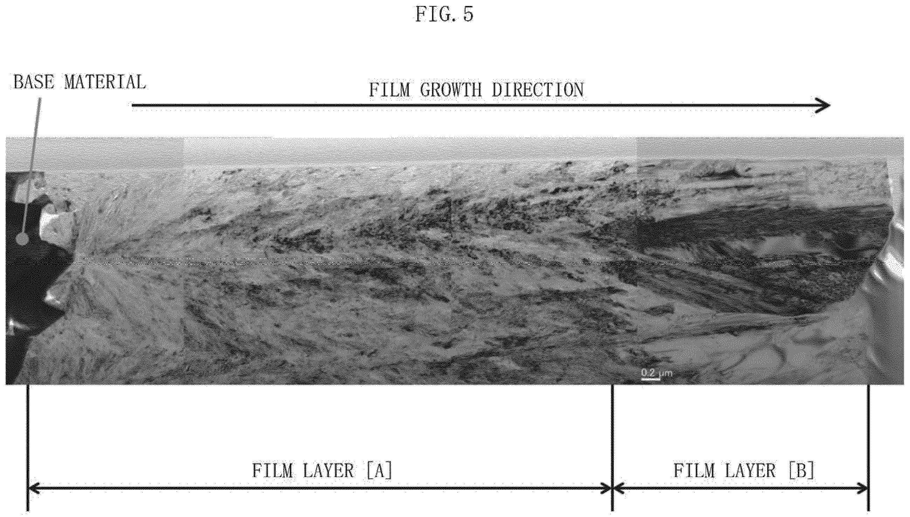

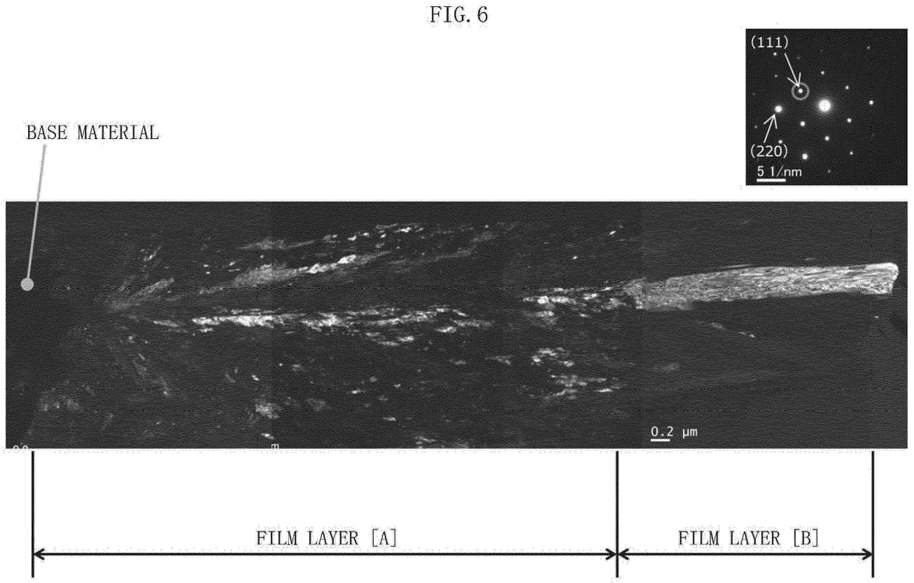

XTEM images of the tool of experimental example 2 of FIG. 4 is shown in FIGS. 5 and 6. FIG. 5 is a bright field image and FIG. 6 is a dark field image.

The electron beam diffraction image in the upper-right of FIG. 6 is an electron beam diffraction image obtained by exposing the sample diamond film to an electron beam; for lattice spacing d, 2.04 ± 0.10 Å was consistent with the (111) surface of the diamond, and 1.24 ± 0.10 Å was consistent with the (220) surface of the diamond. Therefore, this film can be said to be a diamond film from the electron beam diffraction image of the film.

For the electron beam diffraction image in the upper-right of FIG. 6, the crystal surface (the (111) surface) enclosed by the circle was imaged to photograph the dark field image of FIG. 6.

From FIG. 6, it was observed that the crystal grain diameter in the film layer [A] was smaller than in the film layer [B].

As a result of measuring the width of crystal grains in a direction perpendicular to the film growth direction of the film layer [A], it was confirmed that the width of the crystal grains was 0.005-0.15 *µ*m (inclusive).

Similarly, as a result of measuring the width of crystal grains in a direction perpendicular to the film growth direction of the film layer [B], it was confirmed that the width of the crystal grains was 0.2-0.4 *µ*m (inclusive).

From experiment results such as the above, the film thickness and crystal grain diameter of the present example were set to the ranges given above.

## Claims

1. A diamond film for cutting tools formed on a base material, wherein the base material is a cutting tool for machining PCBs, the diamond film having a film thickness of 5-20 *µ*m and being **characterized in that** the diamond film has a two-layer configuration composed of a film layer [A] which is provided directly on top of the base material and a film layer [B] which is provided on the film layer [A], and **in that**, when spectroscopic analysis of Raman scattering is performed on a film cross-section of a tool distal end using laser light having a wavelength of 532 nm, the intensity ratio IN/IJ of IJ and IN defined below is 0.01-0.30 at an arbitrary measurement position A, which lies within the film layer [A], in a range of 0.5 *µ*m from a base material surface, and is 1.00-30.25 at an arbitrary measurement position B, which lies within the film layer [B], in a range of 0.5 *µ*m from a film surface, and an intensity ratio IN/IQ between IQ and IN defined below is 0.15-1.30 at the measurement position A, and is 1.50-45.36 at the measurement position B, wherein
a thickness of the film layer [B] is set to a range of 0.2-10 *µ*m,
a crystal grain diameter at the measurement position A is smaller than a crystal grain diameter at the measurement position B,
a width of crystal grains in a direction perpendicular to a film growth direction is 0.005-0.15 *µ*m in the film layer [A], and the width of crystal grains in a direction perpendicular to the film growth direction is 0.2-30 *µ*m in the film layer [B], and
when the Raman scattering spectrum as measured by the spectroscopic analysis of Raman scattering is assumed to be the sum of the following seven (1) - (7) Gaussian functions, the peak intensity of J is defined as IJ, the peak intensity of N is defined as IN, and the peak intensity of Q is defined as IQ when the peaks of the Raman scattering spectrum are separated:
(1) J, having a peak at a Raman shift of 1550 ± 40 cm⁻¹
(2) K, having a peak at a Raman shift of 1500 ± 150 cm⁻¹ and a half-value width of 200 cm⁻¹ or more
(3) L, having a peak at a Raman shift of 1470 ± 30 cm⁻¹
(4) M, having a peak at a Raman shift of 1340 ± 40 cm⁻¹
(5) N, having a peak at a Raman shift of 1330 ± 20 cm⁻¹ and a half-value width of 20 cm⁻¹ or less
(6) P, having a peak at a Raman shift of 1200 ± 40 cm⁻¹
(7) Q, having a peak at a Raman shift of 1130 ± 20 cm⁻¹

## Patentansprüche

1. Diamantfilm für Schneidwerkzeuge, der auf einem Basismaterial ausgebildet ist, bei dem das Basismaterial ein Schneidwerkzeug für die Bearbeitung von Leiterplatten ist, bei dem der Diamantfilm eine Filmdicke von 5-20 *µ*m aufweist und **dadurch gekennzeichnet ist, dass** der Diamantfilm einen Zweischichtaufbau aufweist, der aus einer Filmschicht (A), die unmittelbar auf dem Basismaterial vorgesehen ist, und einer Filmschicht (B), die auf der Filmschicht (A) vorgesehen ist, zusammengesetzt ist, und dadurch, dass, wenn eine spektroskopische Analyse der Raman-Streuung an einem Filmquerschnitt eines distalen Endes des Werkzeugs unter Verwendung von Laserlicht mit einer Wellenlänge von 532 nm durchgeführt wird, das Intensitätsverhältnis IN/IJ von IJ und IN, die nachfolgend definiert sind, an einer willkürlichen Messposition A, die innerhalb der Filmschicht (A) in einem Bereich von 0,5 *µ*m von einer Basismaterialoberfläche liegt, 0,01-0,30 beträgt und an einer willkürlichen Messposition B, die innerhalb der Filmschicht (B) in einem Bereich von 0,5 *µ*m von einer Filmoberfläche liegt, 1,00-30,25 beträgt, und ein Intensitätsverhältnis IN/IQ zwischen IQ und IN, die nachfolgend definiert sind, an der Messposition A 0,15-1,30 beträgt und an der Messposition B 1,50-45,36 beträgt, bei dem
eine Dicke der Filmschicht (B) in einem Bereich von 0,2-10 *µ*m eingestellt ist,
ein Kristallkorndurchmesser an der Messposition A kleiner ist als ein Kristallkorndurchmesser an der Messposition B,
eine Breite der Kristallkörner in einer Richtung senkrecht zu einer Filmwachstumsrichtung 0,005-0,15 *µ*m in der Filmschicht (A) beträgt und die Breite der Kristallkörner in einer Richtung senkrecht zu der Filmwachstumsrichtung 0,2-30 *µ*m in der Filmschicht (B) beträgt, und
wenn das durch die spektroskopische Analyse der Raman-Streuung gemessene Raman-Streuungsspektrum als die Summe der folgenden sieben Gaussfunktionen (1)-(7) angenommen wird, die Spitzenintensität von J als IJ definiert ist, die Spitzenintensität von N als IN definiert ist und die Spitzenintensität von Q als IQ definiert ist, wenn die Spitzen des Raman-Streuungsspektrums getrennt sind:
(1) J, eine Spitze bei einer Raman-Verschiebung von 1550 ± 40 cm⁻¹ aufweist
(2) K, eine Spitze bei einer Raman-Verschiebung von 1500 ± 150 cm⁻¹ und eine Halbwertsbreite von 200 cm⁻¹ oder mehr aufweist
(3) L, eine Spitze bei einer Raman-Verschiebung von 1470 ± 30 cm⁻¹ aufweist
(4) M, eine Spitze bei einer Raman-Verschiebung von 1340 ± 40 cm⁻¹ aufweist
(5) N, eine Spitze bei einer Raman-Verschiebung von 1330 ± 20 cm⁻¹ und eine Halbwertsbreite von 20 cm⁻¹ oder weniger aufweist
(6) P, eine Spitze bei einer Raman-Verschiebung von 1200 ± 40 cm⁻¹ aufweist
(7) Q, eine Spitze bei einer Raman-Verschiebung von 1130 ± 20 cm⁻¹ aufweist

## Revendications

1. Un film de diamant pour outils de coupe formé sur un matériau de base, dans lequel le matériau de base est un outil de coupe pour l'usinage de PCB, le film de diamant ayant une épaisseur de 5 à 20 µm et étant **caractérisé en ce que** le film de diamant a une configuration de film à deux couches composée d'une couche de film [A] qui est prévue directement au-dessus du matériau de base et d'une couche de film [B] qui est prévue sur la couche de film [A], et **en ce que**, lorsqu'une analyse spectroscopique de diffusion Raman est effectuée sur une section transversale de film d'une extrémité distale d'outil en utilisant une lumière laser ayant une longueur d'onde de 532 nm, le rapport d'intensité IN/IJ de IJ et IN défini ci-dessous est de 0,01 - 0,30 à une position de mesure A arbitraire, qui se trouve à l'intérieur de la couche de film [A], dans une plage de 0,5 µm à partir d'une surface de matériau de base, et est de 1,00 - 30,25 à une position de mesure B arbitraire, qui se trouve à l'intérieur de la couche de film [B], dans une plage de 0,5 µm à partir d'une surface de film, et un rapport d'intensité IN/IQ entre IQ et IN défini ci-dessous est de 0,15 - 1,30 à la position de mesure A, et est de 1,50 - 45,36 à la position de mesure B, dans lequel
une épaisseur de la couche de film [B] est fixée à une plage de 0,2 - 10 µm,
un diamètre de grain cristallin à la position de mesure A est inférieur à un diamètre de grain cristallin à la position de mesure B,
une largeur de grains cristallins dans une direction perpendiculaire à une direction de croissance de film est de 0,005 à 0,15 µm dans la couche de film [A], et la largeur des grains cristallins dans une direction perpendiculaire à la direction de croissance de film est de 0,2 à 30 µm dans la couche de film [B], et
lorsque le spectre de diffusion Raman tel que mesuré par l'analyse spectroscopique de diffusion Raman est supposé être la somme des sept fonctions gaussiennes (1) à (7) suivantes, l'intensité de pic de J est définie comme IJ, l'intensité de pic de N est définie comme IN, et l'intensité de pic de Q est définie comme IQ lorsque les pics du spectre de diffusion Raman sont séparés :
(1) J, ayant un pic à un décalage Raman de 1550 ± 40 cm⁻¹
(2) K, ayant un pic à un décalage Raman de 1500 ± 150 cm⁻¹ et une largeur à mi-hauteur de 200 cm⁻¹ ou plus
(3) L, ayant un pic à un décalage Raman de 1470 ± 30 cm⁻¹
(4) M, ayant un pic à un décalage Raman de 1340 ± 40 cm⁻¹
(5) N, ayant un pic à un décalage Raman de 1330 ± 20 cm⁻¹ et une largeur à mi-hauteur de 20 cm⁻¹ ou moins
(6) P, ayant un pic à un décalage Raman de 1200 ± 40 cm⁻¹
(7) Q, ayant un pic à un décalage Raman de 1130 ± 20 cm⁻¹.
